# EUROPEAN PATENT APPLICATION

(11) **EP 4 797 325 A1**
(43) Date of publication of application: **26.08.2026**
(21) Application number: 24893277.4
(22) Date of filing: 11.11.2024
(51) Int. Cl.: H01L 21/68, H01L 21/67

(54) **SEMICONDUCTOR PROCESS DEVICE AND CALIBRATION APPARATUS THEREFOR**

(30) Priority: 23.11.2023 CN 202311576681
(71) Applicant: Beijing NAURA Microelectronics Equipment Co., Ltd., Beijing 100176 (CN)
(72) Inventor: FANG, Jihao, Beijing 100176 (CN); LIU, Pengliang, Beijing 100176 (CN); LI, Xue, Beijing 100176 (CN)
(74) Representative: Cohausz & Florack
(86) International application number: PCT/CN2024/131188
(87) International publication number: WO 2025/108119

(57) **Abstract**

The present disclosure provides semiconductor process equipment and a calibration apparatus thereof, used to calibrate a position of a wafer, the calibration apparatus includes pushing mechanisms and a driving mechanism, a number of the pushing mechanisms is two or more, each of the pushing mechanisms includes an abutment part, and the abutment part is capable of moving from an initial position to a calibration position thereof, and pushing the wafer to move during a movement process, so as to calibrate the position of the wafer; the driving mechanism is connected with the abutment parts of at least two pushing mechanisms, and is configured to drive the abutment parts of the at least two pushing mechanisms to synchronously move between respective initial positions and respective calibration positions. During a calibration process, the driving mechanism operates to simultaneously drive the two or more pushing mechanisms to operate, and further pushes the wafer to move to the calibration position through the abutment part. The two or more abutment parts operate under driving of the same driving mechanism, and a synchronization rate of operation is higher, thereby avoiding position deviation of the wafer caused by asynchronous operation of the pushing mechanisms, improving accuracy of wafer position calibration, and further improving the yield of a process.

## Description

### TECHNICAL FIELD

The present disclosure relates to the field of semiconductor manufacturing, and in particular, to semiconductor process equipment and a calibration apparatus thereof.

### BACKGROUND

The semiconductor process equipment typically includes a transfer module (TM) and a process module (PM). The PM includes a process chamber, and a chuck is arranged in the process chamber to support and heat a wafer. The accuracy of a position of the wafer on the chuck affects a final process result, and therefore, how to ensure that a robotic arm accurately transfers the wafer to a designated position on the chuck is extremely important. A technical solution of the TM under an atmospheric environment is to calibrate the wafer before the robotic arm picks up the wafer. Considering processing efficiency and cost, a commonly used wafer calibration solution at present adopts a clamping-type aligner, however, the existing clamping-type aligner has problems such as asynchronous wafer clamping, which may cause abnormal wafer process results, or even unqualified process results.

### SUMMARY

The present disclosure aims to at least solve one of the technical problems existing in the prior art, and provides semiconductor process equipment and a calibration apparatus thereof. The present disclosure improves a synchronization rate of clamping and reduces the risk of abnormal process results.

To achieve the objective of the present disclosure, a calibration apparatus is provided, used in semiconductor process equipment to calibrate a position of a wafer, and includes pushing mechanisms and a driving mechanism, where:
a number of the pushing mechanisms is two or more, each of the pushing mechanisms includes an abutment part, the abutment part being capable of moving from an initial position to a calibration position thereof, and pushing the wafer to move during a movement process, so as to calibrate the position of the wafer;
the driving mechanism is connected with abutment parts of at least two of the pushing mechanisms, and is configured to drive the abutment parts of the at least two pushing mechanisms to synchronously move between respective initial positions and respective calibration positions.

In some embodiments, an included angle exists between movement directions of each two adjacent ones of the abutment parts of at least two of the pushing mechanisms, so that each two adjacent ones gradually approach or move away from each other during the movement process; a movement direction is a direction from one of the initial position and the calibration position of the abutment part to another.

In some embodiments, the driving mechanism includes a driving unit and a transmission assembly, and the driving unit is configured to provide a linear driving force to the transmission assembly;
the transmission assembly is configured to convert the linear driving force provided by the driving unit into a driving force for synchronously moving the abutment part of each of the pushing mechanisms between the initial position and the calibration position.

In some embodiments, the transmission assembly includes a push rod, the driving unit is connected with the push rod and is configured to drive the push rod to move along a driving direction of the driving unit;
the push rod is provided with first elongated slots, a number of the first elongated slots is equal to a number of the pushing mechanisms, each of the pushing mechanisms further includes a connection part fixedly connected with the abutment part, the connection part is partially disposed in a corresponding first elongated slot, an extension direction of the first elongated slot forms a first preset included angle with the driving direction, and the extension direction of the first elongated slot forms a second preset included angle with a movement direction of the corresponding abutment part, so that during movement of the push rod along the driving direction, the connection part and the corresponding first elongated slot are capable of relatively moving along the extension direction of the first elongated slot, and at the same time, a hole wall of the first elongated slot is capable of driving the abutment part to move between the initial position and the calibration position through a corresponding connection part.

In some embodiments, the calibration apparatus further includes a plurality of first support bases, each of the first support bases being movably connected with a corresponding abutment part in a one-to-one manner, and each of the first support bases being configured to limit the movement direction of the abutment part when the abutment part moves relative to a corresponding first support base;
the first support base has a support surface for supporting the wafer; the abutment part partially protrudes from the support surface of the corresponding first support base.

In some embodiments, the first support base has a second elongated slot, the second elongated slot extends along the movement direction of the corresponding abutment part, and the abutment part is partially disposed in the second elongated slot and is capable of moving along the second elongated slot.

In some embodiments, the first support base includes a base and a support part, the base being configured to be fixedly connected with a mounting plate, the support part being fixed above the base, and a top surface of the support part being the support surface;
the pushing mechanism further includes a slide assembly, the slide assembly being mounted at the first support base, and two ends of the slide assembly being respectively connected with the abutment part and the connection part; the slide assembly being configured to drive the abutment part and the connection part to move relative to the first support base along the movement direction of the abutment part;
a mounting groove is provided between the base and the support part, the slide assembly is at least partially disposed in the mounting groove, and the support part is further used to limit the slide assembly within the mounting groove.

In some embodiments, a limiting pin is provided in the mounting groove, and the limiting pin is configured to limit a stroke of the slide assembly driving the abutment part and the connection part to move.

In some embodiments, the calibration apparatus further includes at least one second support base, the second support base being provided with a limiting post, and the limiting post being configured, when the abutment parts of at least two pushing mechanisms move to respective calibration positions, to engage with the abutment parts of the at least two pushing mechanisms to limit the wafer.

In some embodiments, the calibration apparatus further includes a limiting part located in a driving direction of the driving mechanism, the limiting part being configured to limit a stroke of the driving mechanism, so that when a preset gap exists between the limiting post and the wafer, the driving mechanism is prevented from driving each of the abutment parts to continue moving.

In some embodiments, a width of the preset gap is greater than or equal to 0.1 mm and less than or equal to 1 mm.

In some embodiments, a diameter of the limiting post gradually decreases from bottom to top.

In some embodiments, the calibration apparatus further includes a detection mechanism for detecting whether a wafer is present, the driving mechanism being used to drive abutment parts of at least two pushing mechanisms to synchronously move from respective initial positions to respective calibration positions after the detection mechanism detects presence of the wafer.

Semiconductor process equipment is also provided in the present disclosure, including a front-end chamber, a process chamber, a transfer chamber, and any one of the above calibration apparatuses, the calibration apparatus being arranged in the transfer chamber and configured to calibrate a position of a wafer.

The present disclosure has the following beneficial effects:
In the technical solution of the semiconductor process equipment and the calibration apparatus thereof provided in the present disclosure, the calibration apparatus is configured to calibrate a position of a wafer, and includes pushing mechanisms and a driving mechanism, where a number of the pushing mechanisms is two or more, each of the pushing mechanisms includes an abutment part, and the abutment part is capable of moving from an initial position to a calibration position thereof, and pushing the wafer to move during the movement process, so as to calibrate the position of the wafer; the driving mechanism is connected with the abutment parts of at least two pushing mechanisms, and is configured to drive the abutment parts of the at least two pushing mechanisms to synchronously move between respective initial positions and respective calibration positions. During a calibration process, the driving mechanism operates to simultaneously drive the two or more pushing mechanisms to move, and further pushes the wafer to move to the calibration position through the abutment parts of the pushing mechanisms. The two or more pushing mechanisms operate under driving of the same driving mechanism, and a synchronization rate of operation is higher, thereby avoiding a position deviation of the wafer caused by asynchronous operation of the pushing mechanisms, improving an accuracy of wafer position calibration, and further improving the yield of the process.

### BRIEF DESCRIPTION OF THE DRAWINGS

FIG. 1 is a schematic structural diagram of a calibration apparatus provided in a specific embodiment of the present disclosure.
FIG. 2 is a schematic structural diagram of the calibration apparatus pushing a wafer in FIG. 1.
FIG. 3 is a schematic diagram of a calibration process.
FIG. 4 is a sectional view of a pushing mechanism connected with a first support base.
FIG. 5 is a top view of the first support base in FIG. 2.
FIG. 6 is a side view of the first support base in FIG. 2.
FIG. 7 is a schematic structural diagram of a slide assembly in FIG. 4.
FIG. 8 is a schematic structural diagram of a slide body in FIG. 7.
FIG. 9 is a top view of a second support base in FIG. 2.
FIG. 10 is a side view of the second support base in FIG. 2.
FIG. 11 is a schematic structural diagram of semiconductor process equipment provided in the present disclosure.

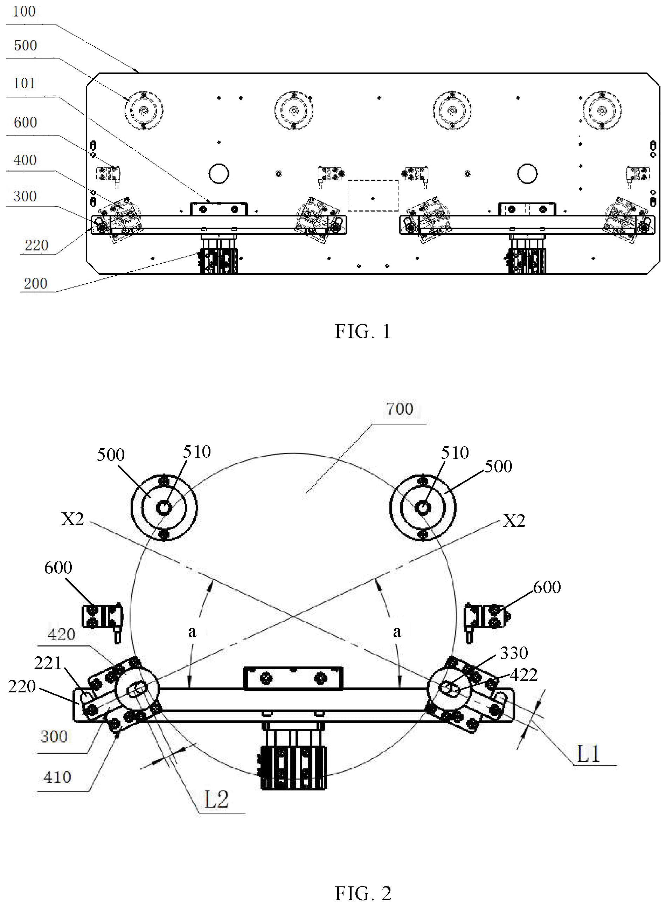

Reference numerals in FIG. 1 to FIG. 11 are as follows:
Mounting plate 100, limiting part 101, driving mechanism 200, push rod 220, first elongated slot 221, pushing mechanism 300, connecting rod 310, bushing 311, slide assembly 320, guide rail 321, connection member 322, slide body 323, connecting rod fixing hole 324, post fixing hole 325, mounting hole 326, post 330, first support base 400, base 410, base fixing hole 411, slide assembly fixing hole 412, limiting pin 413, mounting groove 414, support part 420, connection hole 421, second elongated slot 422, second support base 500, limiting post 510, countersunk hole 520, detection mechanism 600, wafer 700, transfer chamber 1, process chamber 2, calibration apparatus 3, front-end chamber 4, load port (LP) 5, robotic arm 6.

### DETAILED DESCRIPTION OF THE EMBODIMENTS

In order to enable those skilled in the art to better understand the technical solution of the present disclosure, the calibration apparatus provided in the present disclosure is described in detail below with reference to the accompanying drawings.

In the related art, a wafer is placed on a calibration station, the calibration station is further provided with two moving ends and two fixed ends, and two cylinders respectively drive the two moving ends to move, during which the two moving ends push the wafer toward the fixed ends until the wafer engages with the fixed ends, so as to achieve calibration of the wafer. However, in the related art, during the calibration process, the two moving ends may have asynchronous operations due to differences between the two cylinders, thereby causing inconsistent end positions of the two moving ends, and further causing a deviation between a final position reached by the wafer and a target position.

In the related art, during a wafer calibration process, a position of the wafer is limited by fixed ends so as to achieve a calibration purpose. However, during this process, the wafer collides with the fixed ends. After long-term use, the fixed ends are impacted to form grooves, and during wafer pickup, the wafer may tilt due to being stuck in the grooves of the fixed ends, resulting in pickup failure or even wafer damage. Moreover, particles are generated during the collision process, causing contamination of the wafer and affecting yield.

When grooves are formed at the fixed ends, replacement thereof is needed to avoid affecting normal operation of a process. Therefore, in the related art, a service life of the fixed ends is usually relatively short.

In addition, after the position of the wafer is calibrated, an edge of the wafer and the fixed ends are too close or even in contact. When a robotic arm picks up the wafer, an upward movement of the robotic arm causes friction between the wafer and the fixed ends, thereby causing the wafer to tilt and be lifted in a tilted state, and if a tilt angle of the wafer is too large, pickup failure may occur, resulting in unstable wafer transfer.

With reference to FIG. 1 and FIG. 2, the calibration apparatus provided in the present disclosure is used to calibrate a position of a wafer 700. During a process, a transfer apparatus in the semiconductor process equipment is capable of placing the wafer 700 in the calibration apparatus, and a placement position of the wafer 700 is affected by a previous process and has a relatively large position deviation. The calibration apparatus is capable of moving the wafer 700 from the placement position to a target position, so as to achieve calibration of the position of the wafer 700. After calibration, the transfer apparatus in the semiconductor process equipment takes the wafer 700 away for subsequent process processing, so as to ensure that the position of the wafer 700 in subsequent processes is accurate, and avoid accumulated position deviations from affecting processing accuracy and the yield of the wafer 700.

FIG. 1 shows two calibration apparatuses. Each calibration apparatus includes pushing mechanisms 300 and a driving mechanism 200. A number of the pushing mechanisms 300 is two or more, and each of the pushing mechanisms 300 is connected with the driving mechanism 200. The pushing mechanism 300 includes an abutment part, and the abutment part is used to contact an edge of the wafer 700. The driving mechanism 200 is capable of driving each of the pushing mechanisms 300 to operate, so that at least two abutment parts of the pushing mechanisms 300 synchronously move between respective initial positions and respective calibration positions. Before calibration, the wafer 700 is placed, and each of the pushing mechanisms 300 is located at a periphery of the wafer 700, and a distance between abutment parts of two adjacent pushing mechanisms 300 is less than a diameter of the wafer 700. Each abutment part fits with an outer edge of the wafer 700 during movement and applies a pushing force to the wafer 700, and pushing forces of each abutment part form a resultant force to push the wafer 700 toward a target position. When each abutment part reaches the respective calibration position, the wafer 700 is pushed to the target position, thereby achieving calibration of the wafer 700.

The calibration apparatus drives each of the pushing mechanisms 300 to move through one driving mechanism 200, and operation of the pushing mechanisms 300 is not affected by factors such as signal delay, thereby improving a synchronization rate of operation of each of the pushing mechanisms 300, and further avoiding calibration deviation caused by asynchrony, and improving accuracy of calibration of the wafer 700.

The abutment part of each pushing mechanism 300 has a respective initial position and a calibration position, and a movement direction of the abutment part is a direction from the initial position to the calibration position, or from the calibration position to the initial position. Movement directions of the abutment parts may be parallel to each other or may not be parallel. However, if the wafer 700 is inclined in position, and a pushing force applied to the wafer 700 by one abutment part passes through a center of gravity of the wafer 700, the wafer 700 may translate under pushing of the pushing mechanism 300, and finally collide with other components in the calibration apparatus, causing damage to the wafer 700.

In order to solve the above problems, in some embodiments, an included angle exists between movement directions of each two adjacent ones of the abutment parts of at least two pushing mechanisms 300, so that each two adjacent ones (that is, each two adjacent abutment parts) gradually approach or move away from each other during the movement process, thereby reducing a probability that the wafer 700 collides with other components in the calibration apparatus. The movement direction is a direction from one of the initial position and the calibration position of the abutment part to the other. Specifically, for two adjacent abutment parts of adjacent pushing mechanisms 300 whose movement directions form an included angle, a distance between the two adjacent abutment parts at the initial positions is greater than a distance at the calibration positions, so that the two adjacent abutment parts move toward each other while pushing the wafer 700, and cause the wafer 700 to move toward a target position under combined pushing of at least two abutment parts. Further, in some embodiments, at least two abutment parts are, for example, distributed on a circle having an intersection point of movement directions thereof as a center, and a diameter of the circle on which the at least two abutment parts are located is largest at the initial positions and smallest at the calibration positions and matches a diameter of the wafer, and the diameter of the circle decreases during movement from the initial positions to the calibration positions and increases during movement from the calibration positions to the initial positions. Moreover, the intersection point of the movement directions of the at least two abutment parts coincides with a center of the wafer 700 when the wafer 700 is at the target position. In this case, the at least two abutment parts approach the intersection point along respective movement directions, and during this process, a distance between two adjacent abutment parts gradually decreases, thereby pushing the wafer 700 and causing a center thereof to gradually approach the intersection point until coincidence.

The driving mechanism 200 includes a driving unit and a transmission assembly, the driving unit is used to provide a linear driving force to the transmission assembly; the transmission assembly is used to convert the linear driving force provided by the driving unit into a driving force for synchronously moving the abutment parts of each of the pushing mechanisms between initial positions and calibration positions. That is, the transmission assembly is used to transmit between the driving unit and each of the pushing mechanisms 300, and convert the linear driving force into a force for driving each of the pushing mechanisms 300 to synchronously move along respective movement directions. One driving unit drives each of the pushing mechanisms 300 to operate, thereby ensuring that operation of each of the pushing mechanisms 300 has a relatively high synchronization rate.

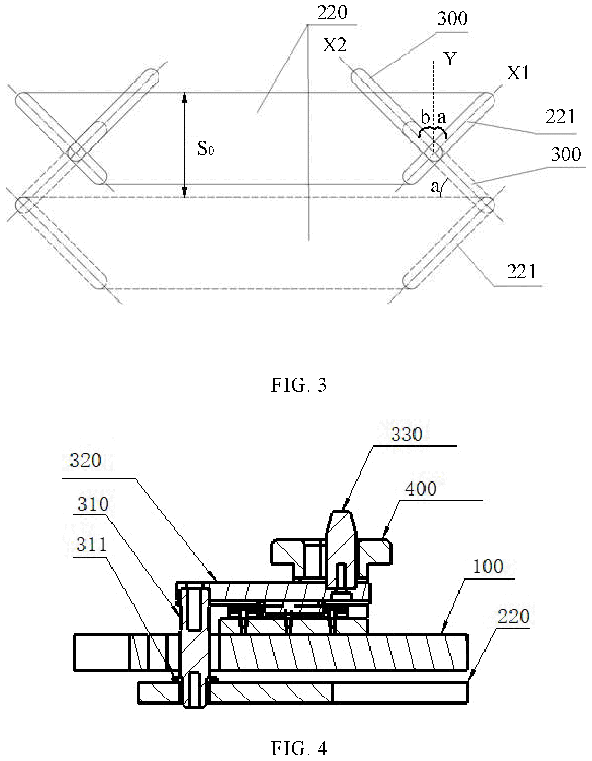

In some embodiments, with reference to FIG. 3, the transmission assembly includes a push rod 220, the driving unit is connected with the push rod 220 and is used to drive the push rod 220 to move along a driving direction of the driving unit (for example, parallel to a Y direction shown in FIG. 3); the push rod 220 is provided with first elongated slots 221, a number of the first elongated slots 221 is equal to a number of the pushing mechanisms 300, and each of the pushing mechanisms 300 corresponds to each of the first elongated slots 221. The pushing mechanism 300 further includes a connection part fixedly connected with the abutment part, and the connection part is partially disposed in a corresponding first elongated slot 221. An extension direction of the first elongated slot 221 (for example, an X1 direction shown in FIG. 3) has a first preset included angle with the driving direction, and the extension direction of the first elongated slot 221 has a second preset included angle (a+b) with a movement direction of the corresponding abutment part (for example, an X2 direction shown in FIG. 3), so that during movement of the push rod 220 along the driving direction, the connection part and the corresponding first elongated slot 221 are capable of relatively moving along the extension direction of the first elongated slot 221, and at the same time, a hole wall of the first elongated slot 221 is capable of driving the abutment part to move between the initial position and the calibration position through the corresponding connection part. Specifically, as shown in FIG. 3, taking the driving direction of the driving unit as vertically upward as an example, the push rod 220 moves from a dashed-line position to a solid-line position from bottom to top, and similarly, the first elongated slot 221 on the push rod 220 moves from the dashed-line position to the solid-line position from bottom to top; during this process, relative movement along the X1 direction occurs between the connection part of the pushing mechanism 300 corresponding to the first elongated slot 221 and the first elongated slot 221, for example, the connection part at the dashed-line position is located at an upper end of the first elongated slot 221 at the dashed-line position, and after the first elongated slot 221 moves from the dashed-line position to the solid-line position from bottom to top, the connection part at the solid-line position is located near a lower end of the first elongated slot 221 at the solid-line position, and the connection part moves from the dashed-line position to the solid-line position along the X2 direction, thereby driving the abutment part to move along the X2 direction.

In some embodiments, the driving unit may be a driving cylinder, and the driving cylinder may push the push rod 220 to move along a preset direction, the preset direction being the driving direction of the driving unit (for example, parallel to the Y direction shown in FIG. 3). When the push rod 220 moves along the Y direction, a hole wall of the first elongated slot 221 contacts the corresponding connection part and applies a pushing force to the connection part, so that the connection part moves, thereby driving the abutment part to move. At a contact position between the hole wall of the first elongated slot 221 and the corresponding connection part, since a normal line of the hole wall of the first elongated slot 221 at the contact position (for example, a normal line parallel to the X2 direction in FIG. 3) is perpendicular to the extension direction of the first elongated slot 221 (for example, the X1 direction shown in FIG. 3), the extension direction of the first elongated slot 221 and the movement direction of the corresponding abutment part are perpendicular, that is, the second preset included angle (a+b) is 90°. Further, an inclination direction of the extension direction of the first elongated slot 221 relative to the driving direction of the driving unit is opposite to an inclination direction of the movement direction of the corresponding abutment part relative to the driving direction of the driving unit, for example, as shown on a right side of FIG. 3, the extension direction of the first elongated slot 221 on the right side is inclined to the right relative to the driving direction of the driving unit, and the movement direction of the corresponding abutment part is inclined to the left relative to the driving direction of the driving unit, and inclination angles are the same, that is, a=b. In this way, each two adjacent abutment parts can gradually approach or move away from each other during the movement process.

As shown in FIG. 2, a stroke L2 of the pushing mechanism 300 is a stroke in which the abutment part directly contacts the wafer 700 and pushes the wafer 700 to move, and a stroke S₀ of the push rod 220 is a distance by which the push rod 220 moves during the calibration process. A length L1 of the first elongated slot 221 in the extension direction thereof is greater than or equal to the stroke L2 of the pushing mechanism 300, the stroke S₀ of the push rod 220 is greater than or equal to 2×sin a×L2, and a pushing force of the driving unit (for example, the driving cylinder) is greater than or equal to 2×sin a×f, where f is a friction force applied to the wafer 700 during movement.

In the embodiment shown in FIG. 2, an included angle between the movement direction of the pushing mechanism 300 (for example, the X2 direction shown in FIG. 3) and the extension direction of the push rod 220 (equal to the first preset included angle a) is 45°, and an included angle between the extension direction of the first elongated slot 221 (for example, the X1 direction shown in FIG. 3) and the movement direction of the corresponding pushing mechanism 300 is the second preset included angle (a+b), which is 90°. The length L1 of the first elongated slot 221 is greater than or equal to the stroke L2 of the pushing mechanism 300, the stroke S₀ of the push rod 220 is greater than or equal to 2×sin 45°×L2, and the pushing force of the driving unit (e.g., driving cylinder) is greater than or equal to 2×sin 45°×f, where f is a friction force applied to the wafer 700 during movement. Of course, the first preset included angle a and the second preset included angle (a+b) may be set as needed, and are not limited herein.

For example, as shown in FIG. 2 and FIG. 3, the number of the pushing mechanisms 300 and the first elongated slots 221 is two, and the two first elongated slots 221 are respectively located at two ends of the push rod 220, under a condition that the driving cylinder is located below the push rod 220 in FIG. 3 (the driving cylinder is not shown in FIG. 3), a distance between the two first elongated slots 221 gradually increases from a side of the push rod 220 close to the driving cylinder to a side away from the driving cylinder, that is, the distance between the two first elongated slots 221 gradually increases from bottom to top. Specifically, a piston of the driving cylinder extends from bottom to top to push the push rod 220 to move from bottom to top, such that the push rod 220 moves from a dashed-line position to a solid-line position in FIG. 3. Connection parts of the two pushing mechanisms 300 respectively move along respective movement directions under action of pushing forces of hole walls of the two first elongated slots 221, thereby driving the abutment parts to move from dashed-line positions (initial positions) to solid-line positions (calibration positions). When the wafer 700 is placed, a center of the wafer 700 is located between the two pushing mechanisms 300, the center of the wafer 700 is usually a center of gravity thereof. During movement, the abutment parts of the two pushing mechanisms 300 contact the wafer 700, and resultant force of pushing forces applied to the wafer 700 by the abutment parts of the two pushing mechanisms 300 acts on the center of gravity of the wafer 700, so that the wafer 700 moves along a preset path and finally reaches a target position, thereby completing calibration of the position of the wafer 700. Of course, the number of the pushing mechanisms 300 may also be other numbers, for example, 4, 6, or the like. The push rod 220 may adopt other shapes according to the number of the pushing mechanisms 300, for example, when the number of the pushing mechanisms 300 is 4, the push rod 220 may be arc-shaped, and the 4 first elongated slots 221 are distributed on the push rod 220.

In some embodiments, the calibration apparatus further includes a limiting mechanism, the limiting mechanism limits the movement directions of the pushing mechanisms 300, that is, the limiting mechanism plays a guiding role for the pushing mechanisms 300, so that the pushing mechanisms 300 are capable of moving in a direction from one of the initial position and the calibration position to the other. Specifically, the limiting mechanism may play a guiding role in movement of the abutment part by limiting a movement direction of the connection part of the pushing mechanism 300.

It should be noted that the driving unit and the transmission assembly in the embodiments of the present disclosure are not limited to the above structures, and in practical applications, the driving unit and the transmission assembly may adopt other structures, such as a motor and a cam or the like, which is not limited herein.

In some embodiments, as shown in FIG. 1 and FIG. 4, the calibration apparatus further includes first support bases 400, each of the first support bases 400 is movably connected with a corresponding abutment part in a one-to-one manner, and each of the first support bases 400 is configured to limit a movement direction of the abutment part when the abutment part moves relative to the corresponding first support base 400. The first support base 400 has a support surface for supporting the wafer, support surfaces of a plurality of first support bases 400 are located in the same plane, the wafer 700 is placed on the support surfaces, and the plurality of first support bases 400 jointly support the wafer 700. The abutment part of the pushing mechanism 300 partially protrudes from the support surface of the corresponding first support base 400, so that a part of the abutment part protruding from the support surface is capable of pushing the wafer 700 to move on the support surface of the first support base 400. The first support base 400 may serve as the above limiting mechanism to limit the movement direction of the pushing mechanism 300.

In some embodiments, as shown in FIG. 1 and FIG. 4, the calibration apparatus further includes a mounting plate 100. As shown in FIG. 2, the first support base 400 is mounted at an upper surface of the mounting plate 100, and the driving mechanism 200 is mounted at a lower surface of the mounting plate 100. The driving mechanism 200 (for example, the push rod 220) in FIG. 1 is located at a front side of the mounting plate 100 and is represented by a solid line; the first support base 400 in FIG. 1 is located at a rear side of the mounting plate 100 and is represented by a dashed line. The mounting plate 100 has a through hole penetrating in a thickness direction, and the pushing mechanism 300 is mounted in the first support base 400 and passes through the through hole to engage with the first elongated slot 221.

It should be noted that mounting plates 100 of a plurality of calibration apparatuses may be an integrated structure. In the embodiment shown in FIG. 1, the mounting plates 100 of two calibration apparatuses are an integrated structure, and users may also form mounting plates 100 of three or more calibration apparatuses into an integrated structure as needed, which is not limited herein.

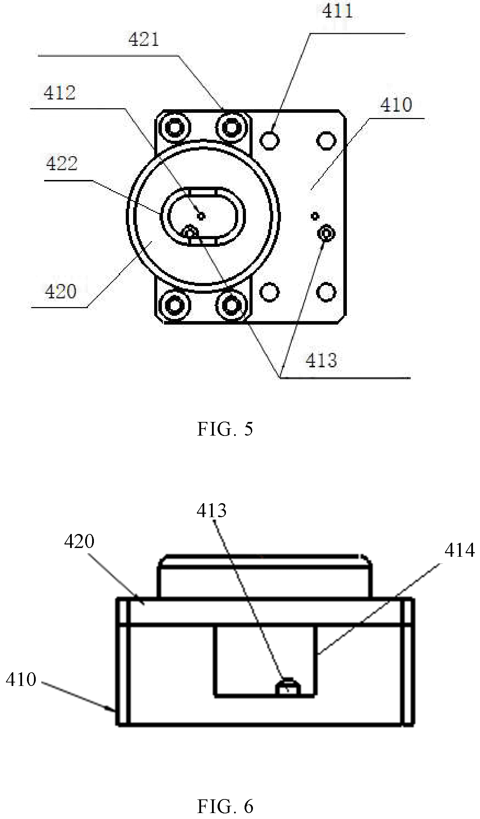

In some embodiments, as shown in FIG. 5, the first support base 400 has a second elongated slot 422, the second elongated slot 422 extends along a movement direction of the corresponding abutment part, the abutment part is partially disposed in the second elongated slot 422, and is capable of moving along the second elongated slot 422, thereby pushing the wafer 700 on the support surface to move.

Further, in some embodiments, as shown in FIG. 4 and FIG. 5, the first support base 400 includes a base 410 and a support part 420, the base 410 is used to be fixedly connected with the mounting plate 100, the support part 420 is fixed above the base 410, and a top surface of the support part 420 is the support surface for supporting the wafer 700. On this basis, the pushing mechanism 300 further includes a slide assembly 320, the slide assembly 320 is mounted at the first support base 400 (for example, the base 410), and two ends of the slide assembly 320 are respectively connected with the abutment part and the connection part; the slide assembly 320 is used to drive the abutment part and the connection part to move relative to the first support base 400 (for example, the base 410) along the movement direction of the abutment part, that is, the abutment part and the connection part realize a movable connection with the first support base 400 (e.g., the base 410) via the slide assembly 320. As shown in FIG. 6, a mounting groove 414 is provided between the base 410 and the support part 420, the slide assembly 320 is at least partially disposed in the mounting groove 414, and the support part 420 is further used to limit the slide assembly 320 within the mounting groove 414.

In some embodiments, as shown in FIG. 4, the connection part is a connecting rod 310, and the abutment part is a post 330, in the embodiment in which the first support base 400 has the second elongated slot 422, the post 330 passes through the second elongated slot 422 and partially protrudes from the support surface. When the pushing mechanism 300 moves, the post 330 moves within the second elongated slot 422, thereby pushing the wafer 700 on the support surface to move. One end of the connecting rod 310 is connected with the slide assembly 320, and another end passes through the through hole of the mounting plate 100 and is inserted into the first elongated slot 221. When the push rod 220 moves, a pushing force is applied through the connecting rod 310 to move the pushing mechanism 300, that is, the slide assembly 320 drives the post 330 to move relative to the base 410 along the extension direction of the second elongated slot 422.

In some embodiments, a bushing 311 is sleeved on an outer periphery of the connecting rod 310, and the bushing 311 is inserted into the first elongated slot 221 to reduce friction between side walls of the first elongated slot 221 and the connecting rod 310, thereby reducing wear of the connecting rod 310.

For example, as shown in FIG. 5 and FIG. 6, the base 410 is provided with a base fixing hole 411, and fasteners such as screws or bolts pass through the base fixing hole 411 and fixing holes on the mounting plate 100, thereby realizing fixed connection between the base 410 and the mounting plate 100. The support part 420 includes a connection plate and a support platform, and the connection plate is provided with a connection hole 421 for connecting with the base 410. Fasteners such as screws or bolts pass through the connection hole 421 and a corresponding hole on the base 410 below, thereby realizing fixed connection between the connection plate of the support part 420 and the base 410, the support platform of the support part 420 is located at an upper surface of the connection plate, and the support surface is an upper surface of the support platform. The second elongated slot 422 penetrates through the support part 420, and the post 330 of the pushing mechanism 300 passes through the second elongated slot 422 and partially protrudes from the support surface.

As shown in FIG. 6, a mounting groove 414 is provided between the base 410 and the support part 420, and the slide assembly 320 is at least partially disposed in the mounting groove 414. The mounting groove 414 is formed at an upper surface of the base 410, the slide assembly 320 may be at least partially disposed in the mounting groove 414, and the support part 420 closes an upward opening of the mounting groove 414 to prevent the slide assembly 320 from sliding out from the opening. Side walls of the mounting groove 414 and the support part 420 are capable of limiting a movement direction of the slide assembly 320, so that the slide assembly 320 always moves along a horizontal direction.

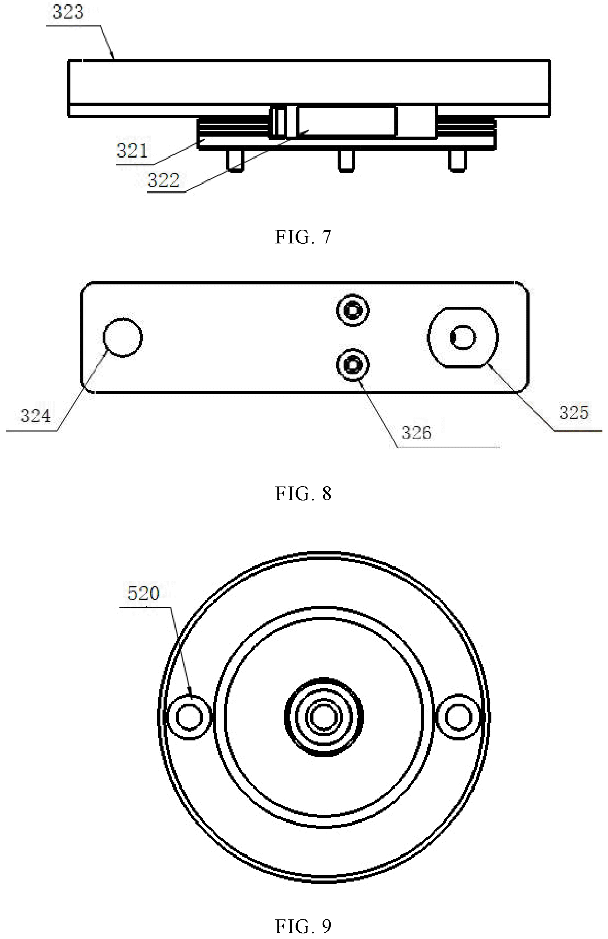

The slide assembly 320 capable of achieving the above functions may have various structures, and in some embodiments, as shown in FIG. 7, the slide assembly 320 includes a slide body 323, connection members 322, and a guide rail 321. A lower surface of the guide rail 321 is provided with fixing pins, an upper surface of the base 410 is provided with slide assembly fixing holes 412, and the fixing pins are fixedly connected with the base 410 through the slide assembly fixing holes 412. The slide body 323 is disposed above the guide rail 321, and as shown in FIG. 8, mounting holes 326 are provided at a lower surface of the slide body 323. The number of the connection members 322 is two, and the two connection members 322 are respectively fixedly connected with the lower surface of the slide body 323 through two mounting holes 326, a sliding groove is formed between the two connection members 322 and the slide body 323, and the guide rail 321 is located in the sliding groove. As shown in FIG. 8, two ends of the slide body 323 are respectively provided with a connecting rod fixing hole 324 and a post fixing hole 325, one end of the connecting rod 310 is disposed in the connecting rod fixing hole 324 to transmit a pushing force to the slide body 323, so that the slide body 323 is capable of moving along the guide rail 321, and one end of the post 330 is disposed in the post fixing hole 325 to move under driving of the slide body 323.

Further, in some embodiments, a limiting pin 413 is provided in the mounting groove 414, and the limiting pin 413 is used to limit a stroke of the slide assembly 320 driving the abutment part and the connection part to move. As shown in FIG. 5 and FIG. 6, the limiting pin 413 is arranged at a bottom surface of the mounting groove 414. The number of the limiting pins 413 may be two, and the two limiting pins 413 are located at the same side of the guide rail 321. The connection member 322 is located between the two limiting pins 413, and the two limiting pins 413 are capable of limiting the connection member 322, thereby limiting a stroke of the slide body 323, so as to limit movement strokes of the abutment part and the connection part.

In some embodiments, a roughness of the support surface of the first support base 400 is relatively small, so as to prevent the support surface from scratching a back surface of the wafer 700 and reduce particles generated during movement of the wafer 700. In addition, edges of the support surface are provided with transition fillets to avoid damage to the back surface of the wafer 700 by the edges of the support surface.

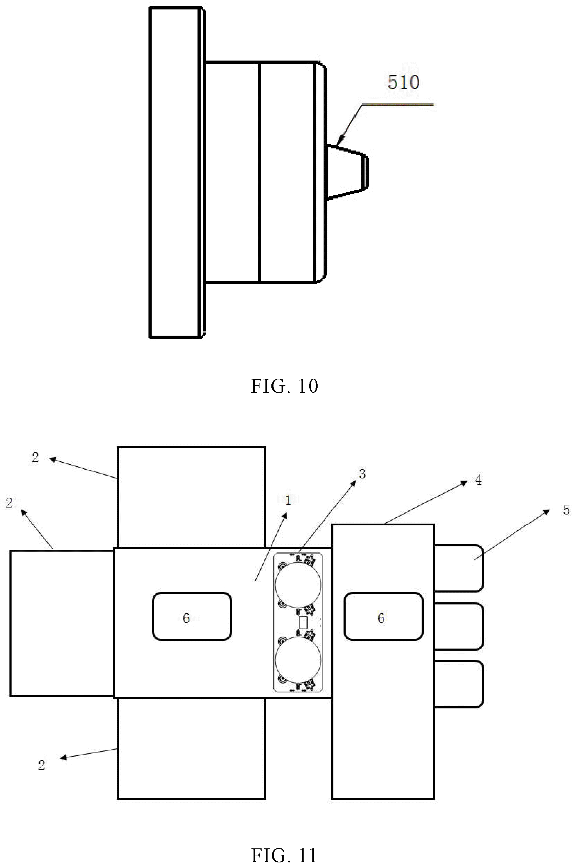

In some embodiments, as shown in FIG. 1 and FIG. 2, the calibration apparatus further includes a second support base 500, an upper surface of the second support base 500 is a support surface for supporting the wafer 700, that is, a bearing surface of the second support base 500 and the support surface of the first support base 400 are used to jointly support the wafer 700. As shown in FIG. 2 and FIG. 10, the second support base 500 is provided with a limiting post 510, and the limiting post 510 is used, when abutment parts of at least two pushing mechanisms 300 move to respective calibration positions, to cooperate with the abutment parts of the at least two pushing mechanisms 300 to limit the wafer 700. Specifically, the limiting post 510 protrudes from the support surface of the second support base 500 to limit the wafer 700. As shown in FIG. 1, the second support base 500 is fixed at an upper surface of the mounting plate 100 (that is, a rear side of the mounting plate 100 in FIG. 1), and the second support base 500 cooperates with the first support base 400 to support the wafer 700. For example, the number of the first support bases 400 and the number of the second support bases 500 are both two. The two first support bases 400 and the two second support bases 500 may be arranged in a rectangular distribution or an isosceles trapezoidal distribution, a center of the wafer 700 may be located within a quadrilateral formed by the two first support bases 400 and the two second support bases 500, and posts 330 of the two first support bases 400 move to push the wafer 700 to a target position, thereby completing calibration of the position of the wafer 700.

In some embodiments, as shown in FIG. 9, the second support base 500 is provided with a countersunk hole 520, and fasteners such as screws or bolts pass through the countersunk hole 520 and mounting holes on the mounting plate 100, thereby realizing fixed connection between the second support base 500 and the mounting plate 100, heads of the screws or bolts are accommodated in the countersunk hole 520 to avoid contact with the wafer 700. Of course, the number and fixing manner of the second support bases 500 are not limited thereto.

When the wafer 700 moves to the target position, collision between the wafer 700 and the limiting post 510 needs to be avoided. In a specific embodiment of the present disclosure, the calibration apparatus is used to calibrate a wafer having a diameter of 300 mm. A distance between a center of the second support base 500 and a center of the wafer 700 at the target position is 150.5 mm. When the wafer 700 reaches the target position, a preset gap of 0.5 mm exists between an edge of the wafer 700 and the limiting post 510.

In other embodiments, a distance between the center of the second support base 500 and the center of the wafer 700 at the target position may be set according to a size of the wafer 700. As shown in FIG. 3, a magnitude of a stroke of the wafer 700 during the calibration process is equal to S₀·cos a ·sin a, where a is the first preset included angle between the extension direction of the first elongated slot 221 (for example, the X1 direction shown in FIG. 3) and the driving direction, and S₀ is the stroke of the push rod 220, and a distance between the center of the second support base 500 and the center of the wafer 700 at an initial position is not less than a sum of the wafer stroke and the wafer diameter. Of course, the preset gap may adopt other sizes, for example, 0.1 mm to 1 mm, which is not limited herein.

In some embodiments, as shown in FIG. 1, the calibration apparatus further includes a limiting part 101 located in the driving direction of the driving mechanism 200, the limiting part 101 is, for example, arranged at a lower surface of the mounting plate 100, and the limiting part 101 is located in a movement direction of the push rod 220, and is used to limit a stroke of the driving mechanism 200 (for example, the push rod 220), so that when a preset gap exists between the limiting post 510 and the wafer 700, the driving mechanism 200 (for example, the push rod 220) is prevented from driving each abutment part to continue moving. Specifically, a piston of the driving cylinder pushes the push rod 220 to move until the push rod 220 contacts the limiting part 101. At this time, the wafer 700 reaches the target position, and the wafer 700 does not collide with the limiting post 510 of the second support base 500. Generally, when the wafer 700 reaches the target position, a distance between an edge thereof and the two limiting posts 510 is 0.5±0.1 mm. Of course, other methods may also be used to limit the stroke of the push rod 220, and the distance between the center of the second support base 500 and the center of the wafer 700 at the target position may also be set as needed, which is not limited herein.

In this embodiment, contact between the wafer 700 and the limiting post 510 during the calibration process is avoided, on one hand avoiding damage to the wafer 700 caused by collision therebetween, and on the other hand avoiding damage to the limiting post 510 caused by collision, thereby avoiding formation of grooves on the limiting post 510 due to long-term use, not only prolonging a service life of the second support base 500, but also avoiding pickup failure caused by the grooves. In addition, the present solution can avoid generation of particles during the calibration process, thereby avoiding influence of particles on subsequent processes and improving the yield of processing of the wafer 700.

In some embodiments, the post 330 of the pushing mechanism 300 partially protrudes from the support surface of the first support base 400 to form a boss, and diameters of the boss and the limiting post 510 gradually decrease from bottom to top. After calibration of the wafer 700, wafer pickup is needed, that is, the wafer 700 is taken away. Since the diameters of the boss and the limiting post 510 gradually decrease from bottom to top, friction between the wafer 700 and the boss and the limiting post 510 can be avoided during the pickup process, thereby preventing damage to the wafer 700.

In some embodiments, a diameter of the limiting post 510 gradually decreases from bottom to top. This also avoids friction between the wafer 700 and the limiting post 510 during the pickup process, thereby preventing damage to the wafer 700.

In some embodiments, materials of the first support base 400 and the second support base 500 may be selected from materials having relatively low hardness, small friction force, and good wear resistance, for example, polytetrafluoroethylene, polyether ether ketone, or the like, so as to avoid damage to the wafer 700 by support surfaces of the first support base 400 and the second support base 500 during pushing of the wafer 700, and avoid particle contamination of wafer 700 caused by friction. Of course, materials of the first support base 400 and the second support base 500 may also be selected as needed, which is not limited herein.

In some embodiments, the calibration apparatus further includes a detection mechanism 600 for detecting whether the wafer 700 is present, and the driving mechanism (that is, the driving unit) is used to drive abutment parts of at least two pushing mechanisms 300 to synchronously move from respective initial positions to respective calibration positions after the detection mechanism 600 detects presence of the wafer 700, so as to calibrate the position of the wafer 700. As shown in FIG. 1 and FIG. 2, the detection mechanism 600 is located at an upper surface of the mounting plate 100. The detection mechanism 600 may include an infrared emitter and an infrared receiver respectively located at two sides of a placement position of the wafer 700. Infrared rays emitted by the infrared emitter are received by the infrared receiver, indicating that the wafer 700 is not placed in the calibration apparatus. After the wafer 700 is placed, the infrared rays are blocked, and at this time the detection mechanism 600 determines that the wafer 700 is placed in position, and then controls operation of the driving cylinder to automatically calibrate the position of the wafer 700. The detection mechanism 600 can improve automation of the calibration apparatus, reduce labor consumption in the calibration process, and improve calibration efficiency.

The embodiments of the present disclosure further provide semiconductor process equipment, as shown in FIG. 11, including a front-end chamber (Equipment Front End Module, EFEM) 4, a process chamber (Process Module, PM) 2, a transfer chamber (Transfer Module , TM) 1, and the calibration apparatus 3 according to any of the above embodiments, the calibration apparatus 3 being arranged in the transfer chamber 1 and used to calibrate a position of a wafer.

In some embodiments, as shown in FIG. 11, the semiconductor process equipment further includes a load port (LP) 5, and robotic arms 6 are provided in both the front-end chamber 4 and the transfer chamber 1. The wafer is first placed on the load port 5, and the load port 5 transfers the wafer into the front-end chamber 4. The robotic arm 6 in the front-end chamber 4 moves the wafer to the calibration apparatus 3, and the calibration apparatus 3 calibrates the position of the wafer. Subsequently, the robotic arm 6 in the transfer chamber 1 moves the wafer to the process chamber 2. After the wafer completes processing in each process chamber 2, the robotic arm 6 moves the processed wafer to the calibration apparatus 3, and the calibration apparatus 3 calibrates the position of the wafer again. Then, the robotic arm 6 in the front-end chamber 4 takes the wafer from the calibration apparatus 3 and places the wafer in the load port 5. The calibration apparatus 3 calibrates the position of the wafer both before processing and after processing, thereby improving accuracy of the wafer position, avoiding accumulation of position errors, and reducing a risk of collision caused by position deviation of the wafer.

It can be understood that the above embodiments are merely exemplary embodiments used to illustrate the principles of the present disclosure, and the present disclosure is not limited thereto. For those skilled in the art, various modifications and improvements may be made without departing from the spirit and essence of the present disclosure, and these modifications and improvements are also considered to fall within the scope of the present disclosure.

## Claims

1. A calibration apparatus, used in semiconductor process equipment to calibrate a position of a wafer, comprising pushing mechanisms and a driving mechanism, wherein,
a number of the pushing mechanisms is two or more, each of the pushing mechanisms includes an abutment part, the abutment part being capable of moving from an initial position to a calibration position thereof, and pushing the wafer to move during a movement process, so as to calibrate the position of the wafer;
the driving mechanism is connected with abutment parts of at least two of the pushing mechanisms, and is configured to drive the abutment parts of the at least two pushing mechanisms to synchronously move between respective initial positions and respective calibration positions.

2. The calibration apparatus according to claim 1, wherein an included angle exists between movement directions of each two adjacent ones of the abutment parts of at least two of the pushing mechanisms, so that each two adjacent ones gradually approach or move away from each other during the movement process; a movement direction is a direction from one of the initial position and the calibration position of the abutment part to another.

3. The calibration apparatus according to claim 1 or 2, wherein the driving mechanism includes a driving unit and a transmission assembly, and the driving unit is configured to provide a linear driving force to the transmission assembly;
the transmission assembly is configured to convert the linear driving force provided by the driving unit into a driving force for synchronously moving the abutment part of each of the pushing mechanisms between the initial position and the calibration position.

4. The calibration apparatus according to claim 3, wherein the transmission assembly includes a push rod, the driving unit is connected with the push rod and is configured to drive the push rod to move along a driving direction of the driving unit;
the push rod is provided with first elongated slots, a number of the first elongated slots is equal to a number of the pushing mechanisms, each of the pushing mechanisms further includes a connection part fixedly connected with the abutment part, the connection part is partially disposed in a corresponding first elongated slot, an extension direction of the first elongated slot forms a first preset included angle with the driving direction, and the extension direction of the first elongated slot forms a second preset included angle with a movement direction of the corresponding abutment part, so that during movement of the push rod along the driving direction, the connection part and the corresponding first elongated slot are capable of relatively moving along the extension direction of the first elongated slot, and at the same time, a hole wall of the first elongated slot is capable of driving the abutment part to move between the initial position and the calibration position through a corresponding connection part.

5. The calibration apparatus according to claim 4, further comprising a plurality of first support bases, each of the first support bases being movably connected with a corresponding abutment part in a one-to-one manner, and each of the first support bases being configured to limit the movement direction of the abutment part when the abutment part moves relative to a corresponding first support base;
the first support base has a support surface for supporting the wafer; the abutment part partially protrudes from the support surface of the corresponding first support base.

6. The calibration apparatus according to claim 5, wherein the first support base has a second elongated slot, the second elongated slot extends along the movement direction of the corresponding abutment part, and the abutment part is partially disposed in the second elongated slot and is capable of moving along the second elongated slot.

7. The calibration apparatus according to claim 6, wherein the first support base includes a base and a support part, the base being configured to be fixedly connected with a mounting plate, the support part being fixed above the base, and a top surface of the support part being the support surface;
the pushing mechanism further includes a slide assembly, the slide assembly being mounted at the first support base, and two ends of the slide assembly being respectively connected with the abutment part and the connection part; the slide assembly being configured to drive the abutment part and the connection part to move relative to the first support base along the movement direction of the abutment part;
a mounting groove is provided between the base and the support part, the slide assembly is at least partially disposed in the mounting groove, and the support part is further used to limit the slide assembly within the mounting groove.

8. The calibration apparatus according to claim 7, wherein a limiting pin is provided in the mounting groove, and the limiting pin is configured to limit a stroke of the slide assembly driving the abutment part and the connection part to move.

9. The calibration apparatus according to claim 1 or 2, further comprising at least one second support base, the second support base being provided with a limiting post, and the limiting post being configured, when the abutment parts of at least two pushing mechanisms move to respective calibration positions, to engage with the abutment parts of the at least two pushing mechanisms to limit the wafer.

10. The calibration apparatus according to claim 9, further comprising a limiting part located in a driving direction of the driving mechanism, the limiting part being configured to limit a stroke of the driving mechanism, so that when a preset gap exists between the limiting post and the wafer, the driving mechanism is prevented from driving each of the abutment parts to continue moving.

11. The calibration apparatus according to claim 10, wherein a width of the preset gap is greater than or equal to 0.1 mm and less than or equal to 1 mm.

12. The calibration apparatus according to claim 9, wherein a diameter of the limiting post gradually decreases from bottom to top.

13. The calibration apparatus according to claim 1 or 2, further comprising a detection mechanism for detecting whether a wafer is present, the driving mechanism being used to drive abutment parts of at least two pushing mechanisms to synchronously move from respective initial positions to respective calibration positions after the detection mechanism detects presence of the wafer.

14. Semiconductor process equipment, comprising a front-end chamber, a process chamber, a transfer chamber, and the calibration apparatus according to any one of claims 1 to 13, the calibration apparatus being arranged in the transfer chamber and configured to calibrate a position of a wafer.
